# EUROPEAN PATENT SPECIFICATION

(11) **EP 2 738 816 B1**
(45) Date of publication and mention of the grant of the patent: **18.09.2019**
(21) Application number: 12816845.7
(22) Date of filing: 21.03.2012
(51) Int. Cl.: H01L 31/054, H01L 31/05, H01L 31/18, H01L 31/0224

(54) **SOLAR CELL, SOLAR CELL MODULE, AND METHOD FOR PRODUCING SOLAR CELL**
SOLARZELLE, SOLARZELLENMODUL UND VERFAHREN ZUR HERSTELLUNG EINER SOLARZELLE
CELLULE SOLAIRE, MODULE DE CELLULES SOLAIRES ET PROCÉDÉ DE PRODUCTION DE CELLULES SOLAIRES

(30) Priority: 28.07.2011 JP 2011165256
(43) Date of publication of application: 04.06.2014
(73) Proprietor: Panasonic Intellectual Property Management Co., Ltd., Osaka-shi, Osaka 540-6207 (JP)
(72) Inventor: TOHODA Satoshi, Osaka 570-6207 (JP)
(74) Representative: Klunker IP Patentanwälte PartG mbB
(86) International application number: PCT/JP2012/057142
(87) International publication number: WO 2013/014973

(56) References cited:
- WO-A1-2012/115006
- DE-U1-202009 006 542
- JP-A- 06 053 531
- JP-A- 09 260 696
- JP-A- 56 010 977
- JP-A- 2002 217 430
- JP-A- 2010 147 107
- JP-U- 3 168 227
- US-A1- 2005 241 692
- US-A1- 2009 221 111
- US-A1- 2011 168 255

## Description

### TECHNICAL FIELD

The present invention relates to a solar cell, a solar cell module, and a method for producing a solar cell.

### BACKGROUND ART

In the field of solar cells, there is desire to increase the amount of power generated per unit area to improve the efficiency of a solar cell. Under such circumstances, electrode structures for solar cells in which shading loss is reduced have been proposed . JP 3 145 145 U discloses a structure in which finger portions having different widths are used in combination.

US 2011/168255 A1 discloses an electrode structure disposed on a substrate of a solar cell. The electrode structure includes a plurality of bus electrodes and a plurality of finger electrodes. The bus electrodes are separately disposed on the substrate. The finger electrodes are disposed on two sides of the bus electrodes and electrically connect to the bus electrodes. The thicknesses of the finger electrodes are greater than those of the bus electrodes.

US 2005/241692 A1 discloses an electrode for contacting at least one surface of a photovoltaic element wafer , the electrode comprising an electrically insulating optically transparent film, an adhesive layer provided on one surface of said film, and a first plurality of substantially parallel, electrically conductive wires being embedded into the adhesive layer, a part of the surfaces of said wires protruding from the adhesive layer and at least on the surface protruding from the adhesive layer being covered by a coating consisting of an alloy with a low melting point, wherein the wires of the first plurality are electrically connected to a first terminal bar. A PV cell or a PV module comprising at least one electrode may comprise one or more photovoltaic cells with an electrically conductive, antireflective, optically transparent coating on at least one of its surfaces, the wires of the first plurality being soldered onto the coating and onto the respective terminal bars or terminal frames by means of the alloy.

WO 2012/11506 A1, prior art pursuant to Article 54(3) EPC, discloses a screen with a mask member that has opening parts corresponding to an electrode. The electrode pattern is formed such that the line width becomes narrower toward prescribed directions, and the thickness of the mask member is formed to become thinner toward the prescribed directions.

DE 20 2009 006 542 U1 and JP 09 260 696 A show electric contact elements comprising a triangular cross section.

JP 3 168 227 A discloses a front electrode comprising a bus bar and a plurality of finger electrodes formed by screen printing, wherein each finger electrode has a smaller cross sectional area of a front-end tip part as a cross sectional area of its connection part with the bus bar. A height of each finger electrode is initially constant and then gradually decreases with a distance from the bus bar portion.

### SUMMARY OF THE INVENTION

### PROBLEMS TO BE SOLVED BY THE INVENTION

In the structure disclosed in prior art, an improvement in output is achieved by the widths of the finger portions. However, in recent years, there is a demand to further increase the output of a solar cell.

It is therefore an object of the present invention to provide a solar cell having an improved reliability, and a corresponding method for producing such solar cell.

### MEANS FOR SOLVING THE PROBLEMS

The object is solved by the features of the respective independent claims. Further developments and embodiments are defined in the respective dependent claims.

According to one aspect of the present invention, there is provided a solar cell, including, on a frontside thereof, a photoelectric conversion unit and a frontside electrode comprising a bus bar portion and a plurality of finger portions, wherein each of the finger portions comprises a first end portion that extends in a longitudinal direction of the finger portion and a second end portion that is connected to the bus bar portion, wherein the first end portion has a triangular cross
section, and the second end portion has a trapezoidal cross section, wherein a short base and a long base of the trapezoidal cross section are parallel to the frontside and wherein the height of the finger portions is initially constant and then gradually decreases with distance from the bus bar portion.

According to another aspect of the present invention, there is provided a method for producing the aforementioned solar cell, the solar cell comprising a bus bar portion and a finger portion, wherein the bus bar portion and the finger portion are formed by a screen printing method; and a first end portion of the finger portion that extends in a longitudinal direction of the finger portion is formed using a triangular cross section formation condition region in the screen printing method, a second end portion of the finger portion that is connected to the bus bar portion is formed using a trapezoidal cross section formation condition region in the screen printing method.

### ADVANTAGES OF THE INVENTION

By employing the present invention, the output of a solar cell can be improved.

### BRIEF DESCRIPTION OF THE DRAWINGS

FIG. 1 shows (a) a frontside plan view and (b) a backside plan view of a solar cell according to an embodiment of the present invention.
FIG. 2 shows (a) a cross-sectional view taken along line 10 AA in FIG. 1, (b) a cross-sectional view taken along line BB in FIG. 1, and (c) a cross-sectional view taken along line CC in FIG. 1.
FIG. 3 shows a cross-sectional view taken along line DD in FIG. 1.
FIG. 4 shows a cross-sectional view taken along line EE in FIG. 1.
FIG. 5 shows a cross-sectional view of a solar cell module according to an embodiment of the present invention.
FIG. 6 shows relationships between electrode height and 20 screen printing plate opening widths according to an embodiment of the present invention.
FIG. 7 schematically shows cross-sectional shapes for the screen printing plate opening widths shown in FIG. 6.

### MODE FOR CARRYING OUT THE INVENTION

A solar cell 1, a solar cell module 10, and a method for producing the solar cell 1 according to an embodiment of the present invention will be described below in detail with reference to the drawings.

It should be noted that the present invention is not limited to this embodiment. Also, the drawings referred to in the description of the embodiment schematically illustrate the embodiment, and details such as the ratio of sizes of elements illustrated in the drawings may differ from those of actual products. A specific ratio of sizes and other details should be determined while taking the following description into consideration.

### (Solar Cell)

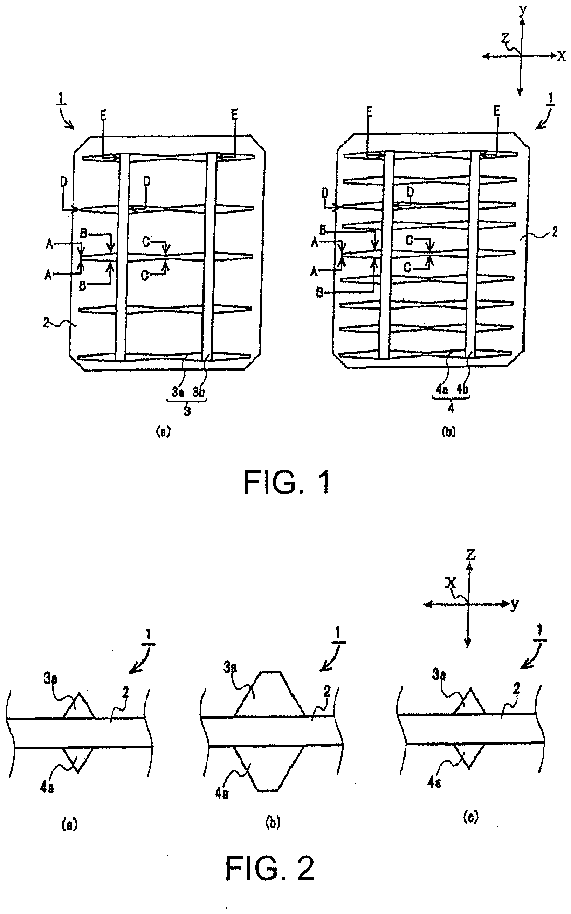

First, frontside and backside structures of the solar cell 1 according to the embodiment of the present invention will be described below with reference to FIG. 1.

FIG. 1(a) is a frontside plan view of the solar cell 1, and FIG. 1(b) is a backside plan view of the solar cell 1.

The solar cell 1 includes, on the frontside, a photoelectric conversion unit 2 and a frontside electrode 3 which is composed of finger portions 3a and bus bar portions 3b.

Although a specific structure of the photoelectric conversion unit 2 is not shown in the drawings, for example, an n-type crystalline silicon substrate is provided, an intrinsic amorphous silicon layer and a p-type amorphous silicon layer are formed, in that order, on the frontside of the substrate, and an intrinsic amorphous silicon layer and an n-type amorphous silicon layer are formed, in that order, on the backside of the substrate. Alternatively, it is also possible to employ a structure in which an n-type amorphous silicon layer is formed on the frontside of an n-type crystalline silicon substrate, and a p-type amorphous silicon layer is formed on the backside of the substrate.

The finger portion 3a is an electrode for collecting carriers generated mainly through photoelectric conversion, and includes a first end portion that extends in an x direction which is a longitudinal direction of the finger portion 3a and a second end portion that is connected to a bus bar portion 3b. The first end portion has a structure in which the width decreases with distance from the bus bar portion 3b, and therefore has a tapered shape. For example, the first end portion has a width of 10 µm to 70 µm, and the second end portion has a width of 75 µm to 200 µm. There are provided 40 to 120 finger portions 3a with a pitch of 1 mm to 3 mm. It is preferable in terms of reducing shading loss that the first end portion has a width of 40 µm, the second end portion has a width of 100 µm, and there are provided 55 finger portions 3a with a pitch of 2.2 mm.

The bus bar portion 3b is an electrode for gathering carriers collected by the finger portions 3a. There are provided two bus bar portions 3b each having a width of 50 µm to 2 mm.

The solar cell 1 includes, on the backside, the photoelectric conversion unit 2 and a backside electrode 4 which is composed of finger portions 4a and bus bar portions 4b.

The finger portion 4a is an electrode for collecting carriers generated mainly through photoelectric conversion, and includes a first end portion that extends in the x direction which is a longitudinal direction of the finger portion 4a and a second end portion that is connected to a bus bar portion 4b. The first end portion has a structure in which the width decreases with distance from the bus bar portion 4b, and therefore has a tapered shape. For example, the first end portion has a width of 10 µm to 70 µm, and the second end portion has a width of 75 µm to 200 µm. There are provided 120 to 480 finger portions 4a with a pitch of 250 µm to 1 mm; that is, with a pitch narrower than the pitch between the finger portions 3a. For the backside as well, it is preferable in terms of reducing shading loss that the first end portion has a width of 40 µm, the second end portion has a width of 80 µm, and there are provided 240 finger portions 3a with a pitch of 500 µm. In the present embodiment, to improve efficiency in utilization of light on the backside as well, the solar cell 1 is a bifacial solar cell. The term "bifacial" means that light can enter the photoelectric conversion unit 2 not only on the frontside of the solar cell 1 but also on the backside of the solar cell 1. Aside from bifacial solar cells, an advantage of the present invention can also be obtained in a monofacial solar cell.

The bus bar portion 4b is an electrode for gathering carriers collected by the finger portions 4a. There are provided two bus bar portions 4b each having a width of 50 µm to 4 mm.

Next, cross-sectional structures of the solar cell 1 according to the present embodiment will be described below with reference to FIG. 2.

FIG. 2(a) is a cross-sectional view taken along line AA in FIG. 1, FIG. 2(b) is a cross-sectional view taken along line BB in FIG. 1, and FIG. 2(c) is a cross-sectional view taken along line CC in FIG. 1.

As shown in FIG. 2(a), the first end portion of each of the finger portions 3a and 4a has a triangular cross section y-z, and has an electrode height of 13 µm. As shown in FIG. 2(b), the second end portion of each of the finger portions 3a and 4a has a trapezoidal cross section y-z, and has an electrode height of 23 µm. As shown in FIG. 2(c), the first end portion of each of the finger portions 3a and 4a has a triangular cross section y-z, and has an electrode height of 13 µm. The terms "triangular" and "trapezoidal" as used herein respectively represent a roughly triangular shape and a roughly trapezoidal shape. More specifically, when compared with a triangular shape and a
trapezoidal shape, a shape closer to a triangular shape is considered to be triangular, and a shape closer to a trapezoidal shape is considered to be trapezoidal. For example, each of the triangular shapes shown in FIGs. 2(a) and 2(c) may have a rounded corner on the tip side in a y direction, and the corner may have a small width. Further, each of the trapezoidal shapes shown in FIG. 2(b) may be any trapezoidal shape whose base on the tip side in the y direction has a certain width.

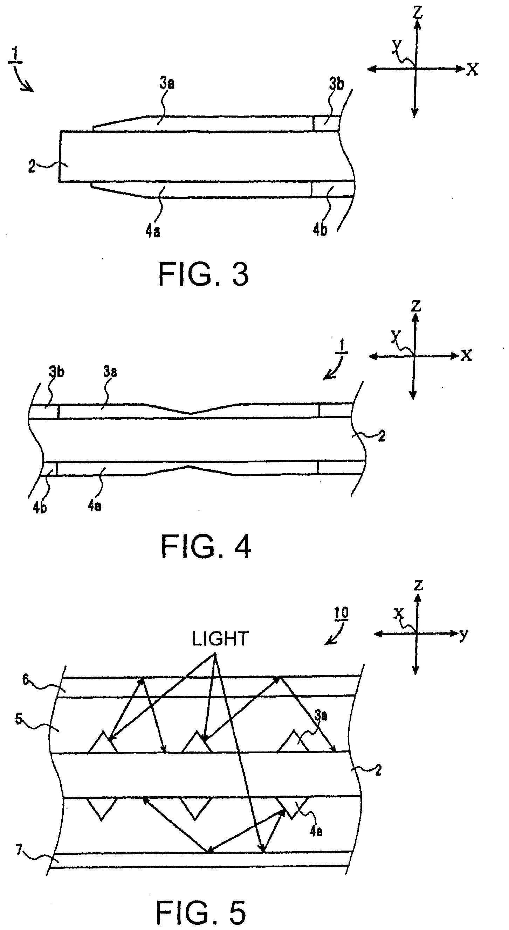

FIG. 3 is a cross-sectional view taken along line DD in FIG. 1.

Each of the finger portions 3a and 4a extending in the x direction has an electrode height which is initially constant, but which then gradually decreases with distance x from the bus bar portion 3b or 4b. In other words, each of the finger portions 3a and 4a is composed of a region in which the electrode height is constant and a region in which the electrode height gradually decreases.

FIG. 4 is a cross-sectional view taken along line EE in FIG. 1.

The first end portions of the finger portions 3a or 4a that are connected to the bus bar portions 3b or 4b are connected to each other between the two bus bar portions 3b and 3b, or between the two bus bar portions 4b and 4b, and each of the finger portions 3a and 4a has an electrode height which is initially constant, but which then gradually decreases with distance from the bus bar portion 3b or 4b. In other words, each of the finger portions 3a and 4a is composed of a region in which the electrode height is constant and a region in which the electrode height gradually decreases, and the first end portions of the finger portions 3a or 4a are connected to each other.

As such, because each of the finger portions 3a and 4a as viewed in a plan view has a tapered shape in which the width decreases with distance from the bus bar portion 3b or 4b in the longitudinal direction of the finger portions 3a or 4a, shading loss can be reduced. Further, because, in addition to having such a tapered shape, each of the first end portions that extend in the longitudinal direction of the finger portions 3a or 4a has a triangular cross section, light entering the finger portions 3a and 4a of the solar cell 1 can be efficiently used to contribute to power generation, as will be described later. As a result, the output of the solar cell 1 can be improved.

Also, the electrode height of each of the finger portions 3a and 4a in the first end portion differs from that in the second end portion. In other words, each of the finger portions 3a and 4a has a region in which the electrode height gradually decreases. With such a structure, because light entering the solar cell 1 at a predetermined angle can be prevented from being blocked due to the electrode height of each of the finger portions, the output of the solar cell 1 can be further improved.

In each of the finger portions 3a and 4a, stress corresponding to volume as measured in the longitudinal direction of the finger portion 3a or 4a is applied to respective areas. As such, stress increases with distance from the bus bar portion 3b or 4b. In other words, greater stress is applied to the first end portions than to the second end portions. However, according to the present embodiment, because the electrode height in the first end portions is lower than that in the second end portions, the increase in stress in the first end portions can be moderated. As a result, the finger portions 3a and 4a can be prevented from peeling off from the photoelectric conversion unit 2, and the reliability of the solar cell 1 can be improved.

### (Solar Cell Module)

FIG. 5 is a cross-sectional view of a solar cell module 10. The solar cell module 10 can be manufactured by placing the above-described solar cell 1 between a frontside protection component 6 and a backside protection component 7 with an encapsulant 5 between them, and performing a known lamination process. As the encapsulant 5, for example, EVA is used. As the frontside protection component 6, for example, glass is used. As the backside protection component 7, for example, PET is used.

FIG. 5 is a cross-sectional view of a portion of the solar cell module 10 where each of the finger portions 3a and 4a has a triangular cross section, and illustrates a state in which light enters the solar cell module 10.

When light enters the solar cell module 10, the light is reflected by a portion constituting a side of the triangular cross section of a finger portion 3a, the reflected light is again reflected by an interface between the frontside protection component 6 and the atmosphere, and the re-reflected light enters the photoelectric conversion unit 2. As a result, because the ratio of light that enters the photoelectric conversion unit 2 increases, the output of the solar cell module 10 is improved. On the other hand, when light that has entered the solar cell module 10 passes through the photoelectric conversion unit 2, the light is reflected by a portion constituting a side of the triangular cross section of a finger portion 4a, the reflected light is again reflected by an interface between the encapsulant 5 and the backside protection component 7, and the re-reflected light enters the photoelectric conversion unit 2. As a result, because the ratio of light that enters the photoelectric conversion unit 2 increases, the output of the solar cell module 10 is improved. Also, when a plurality of solar cells 1 are sealed in a solar cell module 10, the above similarly applies to cases where light enters between the solar cells 1.

### (Method for Producing Solar Cell)

Next, a method for producing a solar cell 1 will be described below.

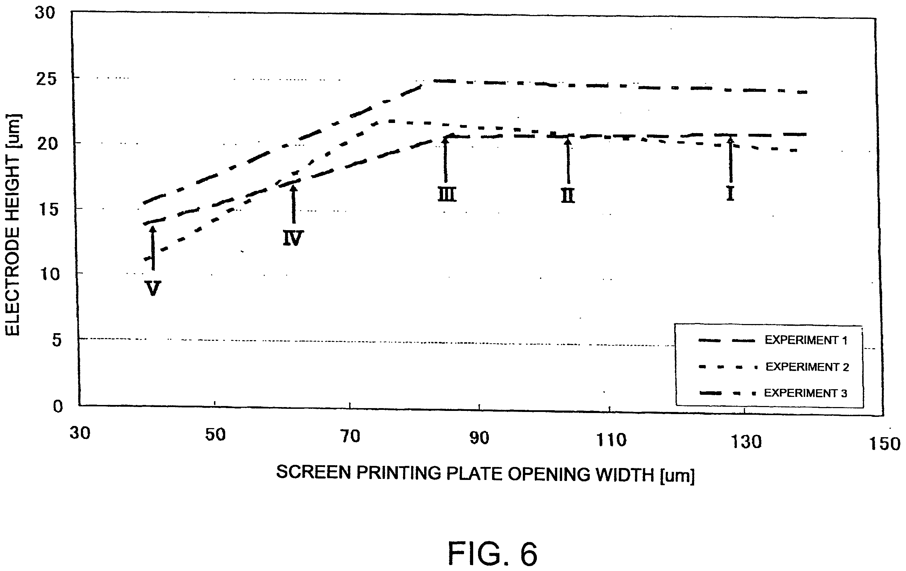

FIG. 6 shows relationships between electrode height and screen printing plate opening widths for cases where finger portions were formed by a screen printing method.

FIG. 6 provides results of Experiments 1 to 3. In Experiments 1 to 3, screen printing was performed under the same conditions. As can also be seen from the results of these experiments, the electrode height of a finger portion is constant when the screen printing plate opening width is greater than a predetermined value, but, when the screen printing plate opening width is equal to or less than the predetermined value, the electrode height of the finger portion gradually decreases as the opening width decreases.

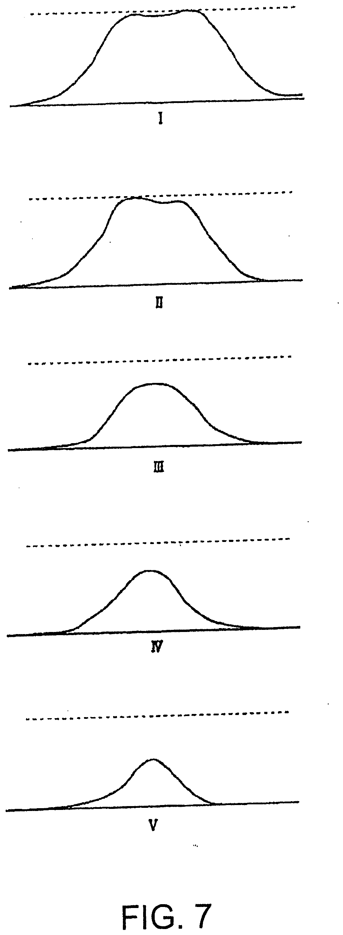

FIG. 7 schematically shows cross-sectional shapes for each of the screen printing plate opening widths I to V in Experiment 1 of FIG. 6. A trapezoidal cross section was observed in a region in which the electrode height of the finger portion was constant, and a triangular cross section was observed in a region in which the electrode height of the finger portion gradually decreases. Similar cross-sectional shapes were also observed in Experiments 2 and 3. In the following description, a region having a screen printing plate opening width that forms a triangular cross section is referred to as a triangular cross section formation condition region, and a region having a screen printing plate opening width that forms a trapezoidal cross section is referred to as a trapezoidal cross section formation condition region. According to the present embodiment, the frontside electrode 3 and the backside electrode 4 that are composed of the finger portions 3a or 4a and the bus bar portions 3b or 4b are respectively formed on the frontside and the backside of the photoelectric conversion unit 2 by a screen printing method.

For each of the finger portions 3a and 4a, there is provided a screen printing plate opening width that forms a tapered shape in which, as described above, the width decreases with distance from the bus bar portion 3b or 4b in the longitudinal direction of the finger portions 3a or 4a. In that process, a screen printing plate opening width constituting a triangular cross section formation condition region is provided for the first end portions, and a screen printing plate opening width constituting a trapezoidal cross section formation condition region is provided for the second end portions.

Because thermosetting silver paste is used in the present embodiment, it is preferable that silver paste having a predetermined viscosity is used.

Also, the bus bar portions 3b or 4b are printed and formed by a screen printing method simultaneously with formation of the finger portions 3a or 4a.

The finger portions 3a and 4a and the bus bar portions 3b and 4b are then dried and cured at 200°C.

The solar cell module 10 is formed by placing the solar cell 1 manufactured by the above-described method between the frontside protection component 6 and the backside protection component 7 by a known method with the solar cell 1 to which a wire material (not shown) is connected being sealed by the encapsulant 5, and performing lamination.

In the method for producing a solar cell according to the present embodiment, because the first end portions that extend in the longitudinal direction of the finger portions 3a or 4a are formed using triangular cross section formation condition regions in the screen printing method, each of the first end portions can be formed to have a triangular cross section. With such a structure, incident light can be efficiently reflected by a portion constituting a triangular shape.

Also, because the second end portions of the finger portions 3a and 4a that are connected to the bus bar portions 3b and 4b are formed using trapezoidal cross section formation condition regions in the screen printing method, each of the second end portions can be formed to have a trapezoidal cross section. With such a structure, because areas over which the finger portions 3a or 4a contact the bus bar portions 3b or 4b can be larger than those in cases where the cross section is formed to be triangular, the connection resistance between the finger portions 3a or 4a and the bus bar portions 3b or 4b can be lowered. As a result, the solar cell 1 can be produced to have an improved output.

Further, because the first end portions of the finger portions 3a or 4a that are connected to different bus bar portions are formed to be connected to each other between the two bus bar portions 3b or 4b using triangular cross section formation condition regions in the screen printing method, each of the connected portions can be formed to have a triangular cross section. As a result, incident light can also be efficiently reflected by a portion having a triangular cross section in the connected portions, and the solar cell 1 can be provided to have an improved output.

It should be noted that each of the bus bar portions 3b or 4b may have a linear shape, or may have a serrated non-linear shape.

Each of the finger portions 3a or 4a may have a single-layer structure, or may have a multi-layer structure. The frontside and the backside may both have the same layer structure which is one of the above-described layer structures, or the layer structure employed on the frontside may differ from that employed on the backside. Also, the screen printing method for forming the finger portions 3a or 4a may be single-layer printing, or may be multi-layer printing.

Further, the photoelectric conversion unit 2 is not limited to that employed in the above-described embodiment. Any structure having the photoelectric conversion function, including, for example, monocrystalline silicon or polycrystalline silicon, may be used.

Further, it is not required that both the finger portions and the bus bar portions are provided on both the frontside and the backside of the photoelectric conversion unit. For example, it is also possible to provide both the finger portions and the bus bar portions on the frontside, and to dispose a metal layer on the backside on the surface of the photoelectric conversion layer to form a structure in which only a bus bar portion is provided, and no finger portion is provided.

### REFERENCE NUMERALS

- 1: SOLAR CELL
- 2: PHOTOELECTRIC CONVERSION UNIT
- 3: FRONTSIDE ELECTRODE
- 3a: FINGER PORTION
- 3b: BUS BAR PORTION
- 4: BACKSIDE ELECTRODE
- 4a: FINGER PORTION
- 4b: BUS BAR PORTION
- 5: ENCAPSULANT
- 6: FRONTSIDE PROTECTION COMPONENT
- 7: BACKSIDE PROTECTION COMPONENT
- 10: SOLAR CELL MODULE

## Claims

1. A solar cell (1), including, on a frontside thereof, a photoelectric conversion unit (2) and a frontside electrode (3) comprising a bus bar portion (3b) and a plurality of finger portions (3a), wherein
each of the finger portions (3a) comprises a first end portion that extends in a longitudinal direction (x) of the finger portion (3a) and a second end portion that is connected to the bus bar portion (3b),
**characterized in that**
the first end portion has a triangular cross section (y-z), and
the second end portion has a trapezoidal cross section (y-z), wherein a short base and a long base of the trapezoidal cross section (y-z) are parallel to the frontside and
wherein the height of the finger portions (3a) is initially constant and then gradually decreases with distance (x) from the bus bar portion (3b).

2. The solar cell (1) according to claim 1, wherein
the first end portion has an electrode height lower than the electrode height of the second end portion.

3. The solar cell (1) according to claim 1 or 2, wherein
the solar cell (1) comprises a plurality of bus bar portions (3b), the bus bar portion (3b) being one of the plurality of bus bar portions (3b), and
between the plurality of bus bar portions (3b), first end portions of finger portions (3a) that are connected to different bus bar portions (3b) are connected to each other.

4. A solar cell module (10) comprising the solar cell (1) according to any one of claims 1 to 3, the solar cell module (10) further comprising:
a frontside protection component (6);
an encapsulant (5); and
a backside protection component (7), wherein
the solar cell (1) is connected by a wire material in the encapsulant (5).

5. A method for producing a solar cell (1) according to any one of claims 1 to 3, wherein the method comprises:
forming the bus bar portion (3b) and the plurality of finger portions (3a) by a screen printing method; and
forming a first end portion of each of the finger portions (3a) that extends in a longitudinal direction (x) of the finger portion (3a) using a triangular cross section (y-z) formation condition region in the screen printing method; and
forming a second end portion of each of the finger portions (3a) that is connected to the bus bar portion (3b) using a trapezoidal cross section (y-z) formation condition region in the screen printing method.

6. The method according to claim 5, further comprising
forming a plurality of bus bar portions (3b) by the screen printing method, the bus bar portion (3b) being one of the plurality of bus bar portions (3b), and
forming between the plurality of bus bar portions (3b), first end portions of finger portions (3a) that are connected to different bus bar portions (3b) using the triangular cross section formation condition region to connect the first end portions of the finger portions (3a) to each other.

## Patentansprüche

1. Eine Solarzelle (1), die auf einer Vorderseite eine photoelektrische Umwandlungseinheit (2) und eine Frontelektrode (3) mit einem Sammelabschnitt (3b) und einer Vielzahl von Fingerabschnitten (3a) beinhaltet, wobei
jeder der Fingerabschnitte (3a) einen ersten Endabschnitt umfasst, der sich in einer Längsrichtung (x) des Fingerabschnitts (3a) erstreckt, und einen zweiten Endabschnitt, der mit dem Sammelabschnitt (3b) verbunden ist,
**dadurch gekennzeichnet, dass**
der erste Endabschnitt einen dreieckigen Querschnitt (y-z) aufweist, und
der zweite Endabschnitt einen trapezförmigen Querschnitt (y-z) aufweist, wobei eine kurze Basis und eine lange Basis des trapezförmigen Querschnitts (y-z) parallel zur Vorderseite verlaufen und
wobei die Höhe der Fingerabschnitte (3a) zunächst konstant ist und dann mit Abstand (x) vom Sammelabschnitt (3b) allmählich abnimmt.

2. Die Solarzelle (1) nach Anspruch 1, wobei
der erste Endabschnitt eine Elektrodenhöhe aufweist, die niedriger ist als die Elektrodenhöhe des zweiten Endabschnitts.

3. Die Solarzelle (1) nach Anspruch 1 oder 2, wobei
die Solarzelle (1) eine Vielzahl von Sammelabschnitten (3b) umfasst, wobei der Sammelabschnitt (3b) einer der Vielzahl von Sammelabschnitten (3b) ist, und
zwischen der Vielzahl von Sammelabschnitten (3b), sind erste Endabschnitte von Fingerabschnitten (3a), die mit verschiedenen Sammelabschnitten (3b) verbunden sind, miteinander verbunden.

4. Ein Solarzellenmodul (10), umfassend die Solarzelle (1) nach einem der Ansprüche 1 bis 3, wobei das Solarzellenmodul (10) ferner umfasst:
eine vorderseitige Schutzkomponente (6);
ein Verkapselungsmittel (5); und
eine rückseitige Schutzkomponente (7), wobei
die Solarzelle (1) durch ein Drahtmaterial in dem Verkapselungsmittel (5) verbunden ist.

5. Verfahren zur Herstellung einer Solarzelle (1) nach einem der Ansprüche 1 bis 3, wobei das Verfahren umfasst:
Bilden des Sammelabschnitts (3b) und der Vielzahl von Fingerabschnitten (3a) durch ein Siebdruckverfahren; und
Bilden eines ersten Endabschnitts von jedem der Fingerabschnitte (3a), der sich in einer Längsrichtung (x) des Fingerabschnitts (3a) erstreckt unter Verwendung eines Dreiecksquerschnitt-(y-z)-Formationsbedingungsbereiches im Siebdruckverfahren; und
Bilden eines zweiten Endabschnitts von jedem der Fingerabschnitte (3a), der mit dem Sammelabschnitt (3b) unter Verwendung eines Trapezquerschnitts-(y-z)-Formationsbedingungsbereichs im Siebdruckverfahren verbunden ist.

6. Verfahren nach Anspruch 5, ferner umfassend
Bilden einer Vielzahl von Sammelabschnitten (3b) durch das Siebdruckverfahren, wobei der Sammelabschnitt (3b) einer der Vielzahl von Sammelabschnitten (3b) ist, und
Bilden zwischen der Vielzahl von Sammelabschnitten (3b), ersten Endabschnitten von Fingerabschnitten (3a), die mit verschiedenen Sammelabschnitten (3b) unter Verwendung des Dreiecksquerschnitt-Formationsbedingungsbereichs verbunden sind, um die ersten Endabschnitte der Fingerabschnitte (3a) miteinander zu verbinden.

## Revendications

1. Cellule solaire (1), comprenant, sur un côté frontal de celle-ci, une unité de conversion photoélectrique (2) et une électrode frontale (3) comprenant une partie de barre omnibus (3b) et une pluralité de parties de doigts (3a), dans laquelle
chacune des parties de doigts (3a) comprend une première partie d'extrémité qui s'étend dans une direction longitudinale (x) de la partie de doigts (3a) et une seconde partie d'extrémité qui est reliée à la partie de barre omnibus (3b),
**caractérisée en ce que**
la première partie d'extrémité a une coupe transversale (y-z) triangulaire et
la seconde partie d'extrémité a une coupe transversale (y-z) trapézoïdale, dans laquelle une base courte et une base longue de la coupe trapézoïdale (y-z) sont parallèles au côté frontal, et
dans laquelle la hauteur des parties de doigts (3a) est initialement constante et diminue ensuite progressivement avec la distance (x) à partir de la partie de barre omnibus (3b).

2. Cellule solaire (1) selon la revendication 1, dans laquelle
la première partie d'extrémité a une hauteur d'électrode inférieure à celle de la hauteur d'électrode de la seconde partie d'extrémité.

3. Cellule solaire (1) selon la revendication 1 ou 2, dans laquelle
la cellule solaire (1) comprend une pluralité de parties de barres omnibus (3b), la partie de barre omnibus (3b) étant une partie de la pluralité de parties de barres omnibus (3b), et
entre la pluralité de parties de barres omnibus (3b), des premières parties d'extrémité de parties de doigts (3a), qui sont reliées à des parties de barres omnibus différentes (3b), sont reliées les unes aux autres.

4. Module de cellule solaire (10) comprenant la cellule solaire (1) selon l'une quelconque des revendications 1 à 3, le module de cellule solaire (10) comprenant en outre :
un composant de protection frontal (6) ;
un élément d'encapsulage (5) ; et
un composant de protection dorsal (7) ; dans lequel
la cellule solaire (1) est reliée par un matériau de fil dans l'élément d'encapsulage (5).

5. Procédé de production d'une cellule solaire (1) selon l'une quelconque des revendications 1 à 3, le procédé comprenant les étapes consistant à :
former la partie de barre omnibus (3b) et la pluralité de parties de doigts (3a) par un procédé d'impression en sérigraphie ; et
former une première partie d'extrémité de chacune des parties de doigts (3a) qui s'étend dans une direction longitudinale (x) de la partie de doigts (3a) à l'aide d'une région de condition de formation de coupe transversale triangulaire (y-z) dans le procédé d'impression en sérigraphie ; et
former une seconde partie d'extrémité de chacune des parties de doigts (3a) qui est reliée à la partie de barre omnibus (3b) à l'aide d'une région de condition de formation de coupe transversale trapézoïdale (y-z) dans le procédé d'impression en sérigraphie.

6. Procédé selon la revendication 5, comprenant en outre les étapes consistant à :
former une pluralité de parties de barres omnibus (3b) par le procédé d'impression en sérigraphie, la partie de barre omnibus (3b) étant une partie de la pluralité de parties de barres omnibus (3b), et
former entre la pluralité de parties de barres omnibus (3b), des premières parties d'extrémité de parties de doigts (3a) qui sont reliées à des parties de barres omnibus différentes (3b) à l'aide de la région de condition de formation de coupe transversale triangulaire pour relier les premières parties d'extrémité des parties de doigts (3a) les unes aux autres.
